# EUROPEAN PATENT APPLICATION

(11) **EP 3 214 654 A1**
(43) Date of publication of application: **06.09.2017**
(21) Application number: 15853676.3
(22) Date of filing: 27.10.2015
(51) Int. Cl.: H01L 29/786, G02F 1/1368, H01L 21/336, H01L 51/05

(54) **THIN-FILM TRANSISTOR ARRAY AND METHOD FOR MANUFACTURING SAME**

(30) Priority: 28.10.2014 JP 2014219530
(71) Applicant: Toppan Printing Co., Ltd., Tokyo 110-0016 (JP)
(72) Inventor: MATSUBARA, Ryohei, Tokyo (JP); ISHIZAKI, Mamoru, Tokyo (JP); NISHIZAWA, Makoto, Tokyo (JP)
(74) Representative: Cabinet Plasseraud
(86) International application number: PCT/JP2015/005386
(87) International publication number: WO 2016/067591

(57) **Abstract**

A thin-film transistor array having high uniformity in transistor characteristics is provided. The thin-film transistor array in which a plurality of thin-film transistors are arranged in a matrix on a substrate, the thin-film transistors each including a source electrode and a drain electrode formed on a gate insulation layer, and a semiconductor layer formed on the gate insulation layer so as to be located between the source electrode and the drain electrode. In the thin-film transistor array, the semiconductor layer is formed into a stripe shape across the plurality of thin-film transistors, with a long axis direction of the stripe coinciding with a channel width direction of a transistor, the semiconductor layer having a cross section in the short axis direction of the stripe such that the semiconductor layer has a thickness gradually decreasing outwardly from a center of the semiconductor.

## Description

### [Technical Field]

The present invention relates to a thin-film transistor array and a method of manufacturing the same.

### [Background Art]

Due to the remarkable development of information technology, information is frequently transmitted/received, currently, with laptop computers or portable information terminals. It is commonly accepted that a ubiquitous society in which information can be exchanged anywhere will be attained in near future. In such a society, lighter and slimmer information terminals are desirable.

Silicon based materials are mainstream semiconductor materials currently, and photolithography is generally used as a method of manufacturing semiconductors.

Printed electronics that is a technique of manufacturing electrical components using a printing technique is attracting attention in recent years. Use of a printing technique can achieve advantages such as of reducing cost incurred in equipment and manufacture compared to photolithography, and enabling use of a plastic substrate which does not need a vacuum and high temperature environment. Further, use of a printing process is advantageous in that materials are highly efficiently utilized, and development and etching can be omitted, leading to producing a smaller amount of waste liquid. Thus, only low environmental loads are imposed by such a printing process.

However, the printing process is likely to produce patterns with low uniformity in film thickness compared to photolithography. For example, when a semiconductor layer in a transistor is formed as described in PTL 1, various printing states can arise depending on the printing conditions, although not described in PTL 1, and accordingly variable transistor characteristics are obtained. Further, the electric current in a transistor array depends on the thickness of the semiconductor film, which may lead to low uniformity in transistor characteristics.

### [Citation List]

### [Patent Literature]

PTL 1: JP-A 2006-063334

### [Summary of the Invention]

### [Technical Problem]

The present invention has been made in light of the circumstances set forth above and has as its object to provide a thin-film transistor array with high uniformity in transistor characteristics.

### [Solution to Problem]

An aspect of the present invention for solving the aforementioned disadvantage is a thin-film transistor array in which a plurality of thin-film transistors are arranged in a matrix on a substrate, the thin-film transistors each including a source electrode and a drain electrode formed on a gate insulation layer, and a semiconductor layer formed on the gate insulation layer so as to be located between the source electrode and the drain electrode. In the thin-film transistor array, the semiconductor layer is formed into a stripe shape across the plurality of thin-film transistors, with a long axis direction of the stripe coinciding with a channel width direction of a transistor, the semiconductor layer having a cross section in the short axis direction of the stripe such that the semiconductor layer has a thickness gradually decreasing outwardly from a center of the semiconductor.

The stripe of the semiconductor layer may have a cross-sectional shape in the short axis direction such that a 10 µm or less distance is ensured between a portion of the semiconductor layer with a maximum thickness and the center of the channel region relative to a channel length direction.

The portion of the semiconductor layer with a maximum thickness may have a thickness in a range of 25 nm or more to 150 nm or less.

The stripe of the semiconductor layer may have a cross-sectional shape in a short axis direction such that the semiconductor layer has a thickness gradually decreasing outwardly from a center, with sub-peaks being provided on both ends of the semiconductor layer, the sub-peaks each having a thickness smaller than the thickness of the center portion.

The sub-peaks on both ends of the semiconductor layer may respectively overlap, in plan view, with the source electrode and the drain electrode.

Another aspect of the present invention is a method of manufacturing the aforementioned thin-film transistor array including a step of forming the semiconductor layer using a relief printing method.

### [Advantageous Effects of the Invention]

According to the present invention, a high quality thin-film transistor array with high uniformity in the transistor characteristics is provided by permitting a portion with a maximum thickness in a cross section of the stripe shaped semiconductor layer to approximately coincide with the center of the channel.

### [Brief Description of the Drawings]

Fig. 1 is a schematic plan view illustrating a thin-film transistor array according to an embodiment.
Fig. 2 is a set of diagrams including a schematic plan view and a schematic cross-sectional view illustrating a thin-film transistor according to an example.
Fig. 3 is a set of diagrams including a schematic plan view and a schematic cross-sectional view illustrating a thin-film transistor according to another example.
Fig. 4 is a set of diagrams including enlarged schematic cross-sectional views each illustrating a cross-sectional shape of a semiconductor layer of a thin-film transistor.

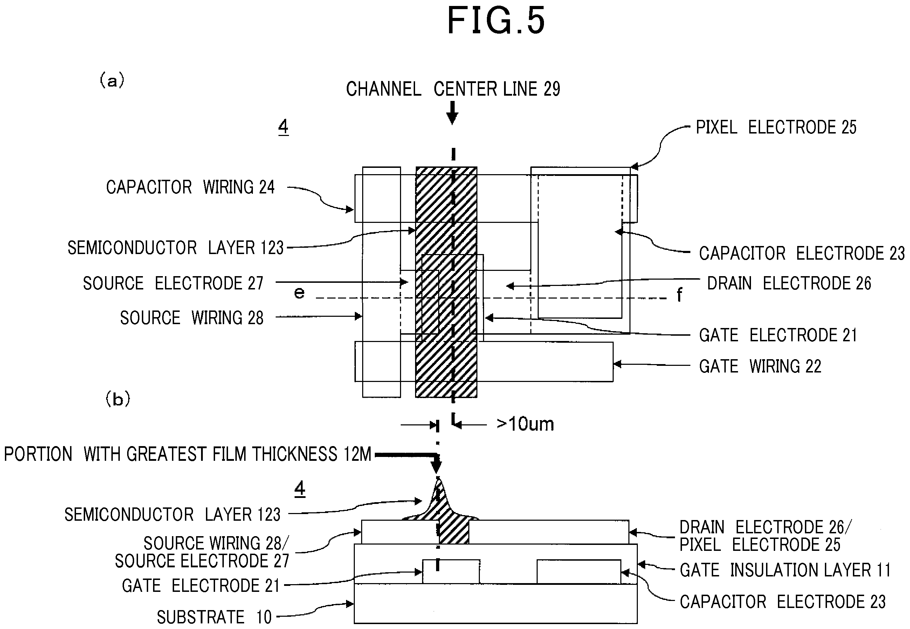

Fig. 5 is a set of diagrams including a schematic plan view and a schematic cross-sectional view illustrating a thin-film transistor according to a comparative example.
Fig. 6 is a set of diagrams including a schematic plan view and a schematic cross-sectional view illustrating a thin-film transistor according to an example.
Fig. 7 is a graph showing a relationship of a maximum thickness of a semiconductor film, with the on- and off-currents, in a thin-film transistor according to an example.
Fig. 8 is a graph showing a relationship of a distance between a maximum thickness position and a channel center of a semiconductor film, with mobility, in the case when the semiconductor width of a thin-film transistor according to an example is changed.
Fig. 9 is a graph showing a relationship of a distance between a maximum thickness position and a channel center of a semiconductor film, with mobility, in the case when the channel length of a thin-film transistor according to an example is changed.

### [Description of the Embodiments]

A thin-film transistor array according to an embodiment of the present application will be described with reference to the drawings.

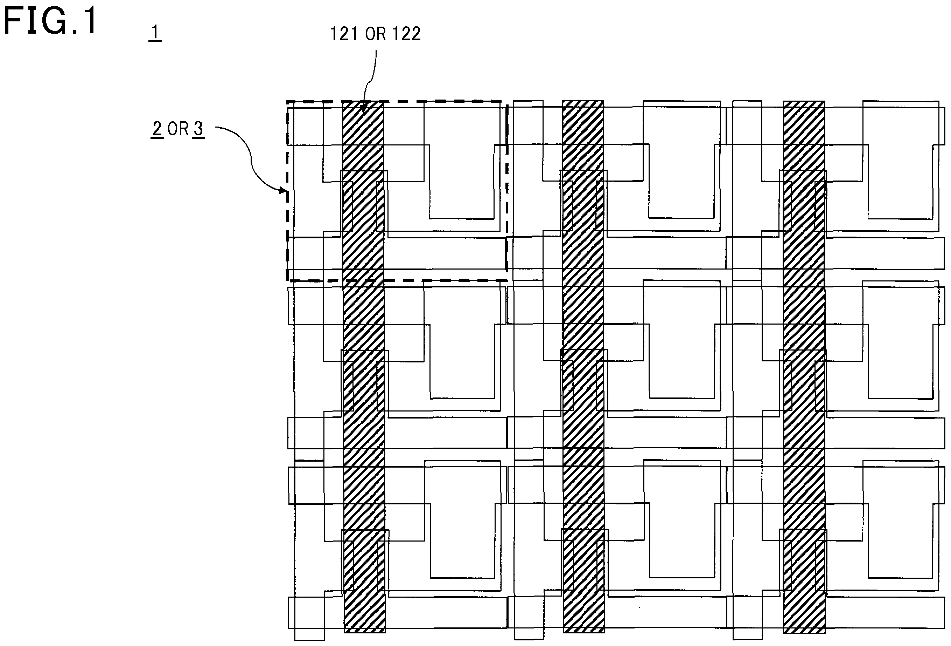

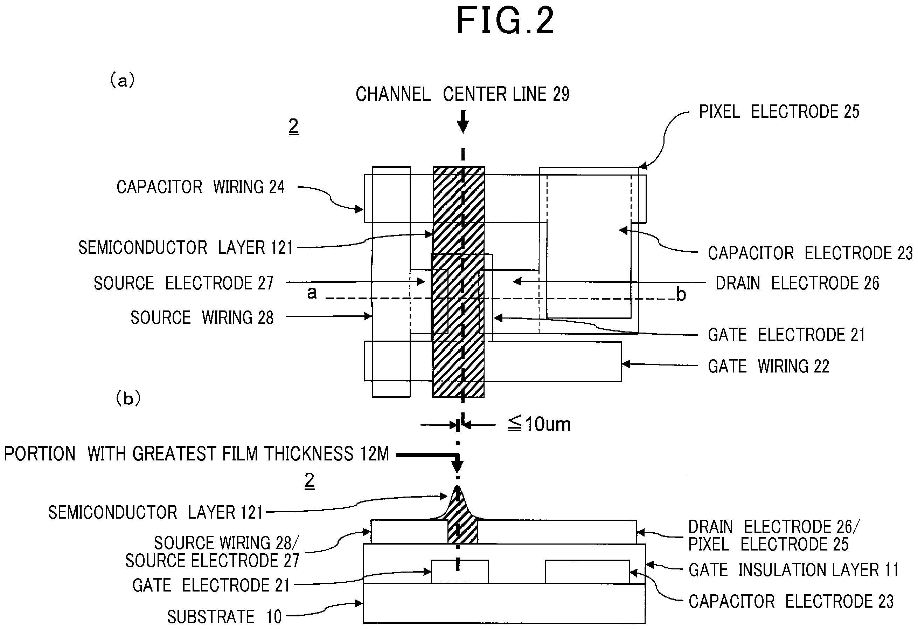

Fig. 1 is a schematic plan view illustrating a thin-film transistor array 1. Fig. 2 is a set of diagrams including a schematic plan view of a thin-film transistor 2 and a schematic cross-sectional view taken along the line a-b of the plan view according to an example of a thin-film transistor configuring the thin-film transistor array 1.

As shown in Fig. 2, the thin-film transistor 2 comprises a gate electrode 21, a gate wiring 22 and a capacitor electrode 23, a gate insulation layer 11 formed on these elements, a pixel electrode 25, a drain electrode 26, a source electrode 27 and a source wiring 28 formed on the gate insulation layer 11, and a semiconductor layer 121 formed between the source electrode 27 and the drain electrode 26 on the gate insulation layer 11. As shown in Fig. 1, the thin-film transistor array 1 is formed by arranging a plurality of thin-film transistors 2 in a matrix on an insulative substrate 10. Further, a connection is established between the gate electrode 21 and the gate wiring 22, between the source electrode 27 and the source wiring 28, and between the pixel electrode 25 and the drain electrode 26.

As shown in Figs. 1 and 2, the semiconductor layer 121 is formed in a stripe shape across the plurality of thin-film transistors 2, with the long axis direction of the stripe coinciding with the channel width direction of the transistor. Specifically, the semiconductor layer 121 is formed such that a distance d of 10 µm or less in plan view is ensured between a portion (thick portion) 12M of the semiconductor layer 121 with a maximum thickness in the short axis direction of the stripe shape semiconductor layer and a center 29 of the channel.

The thin-film transistor 2 configured as described above can achieve high-performance transistor characteristics because the position of the thick portion of the semiconductor layer 121 falls within the channel region if the semiconductor layer 121 is displaced to an extent corresponding to approximately the channel length when forming the semiconductor layer 121. In particular, when the relationship between the thickness of the semiconductor layer 121 and the on-current of the transistor at a predetermined voltage is plotted, the on-current tends to be saturated at a predetermined thickness d1 as a boundary. Specifically, when the thickness of the semiconductor layer 121 of the channel region is larger than the threshold (thickness d1), uniformity of the transistor characteristics improves in the thin-film transistor array. Further, when the relationship between the thickness of the semiconductor layer 121 and the off-current is plotted, the off-current tends to increase in excess of a predetermined thickness d2.

Further, as shown in Fig. 2 (b), the semiconductor layer 121 may have a cross-sectional shape in the short axis direction, in which the thickness gradually decreases towards both directions from the center of the semiconductor stripe area. It should be noted that the thickness of the semiconductor layer 121 referred to herein is not the height of the semiconductor layer 121. Namely, the thickness of the semiconductor layer 121 on the source electrode 27 and the drain electrode 26 is obtained by subtracting the height of the source electrode 27 or the drain electrode 26 from the height of the semiconductor layer 121. Fig. 2 (b) shows that the maximum thickness 12M of the semiconductor layer 121 is larger than the thickness of the source electrode 27 and the drain electrode 26, but the maximum thickness 12M of the semiconductor layer 121 may be smaller than or equal to the thickness of the source electrode 27 and the drain electrode 26.

In the thin-film transistor 2 configured as described above, a part of the semiconductor layer 121 extending out of the channel region without directly contributing to the drain current can be made thinner to reduce the usage amount, thereby reducing cost of the transistor. However, the part of the semiconductor layer 121 extending out of the channel region and present on the source electrode 27 and the drain electrode 26, plays a role of contacting the source electrode 27 and the drain electrode 26 and indirectly contributes to the drain current. Therefore, the semiconductor layer 121 preferably overlaps the source electrode 27 and the drain electrode 26 to some extent (e.g., an overlap of 15 µm or more).

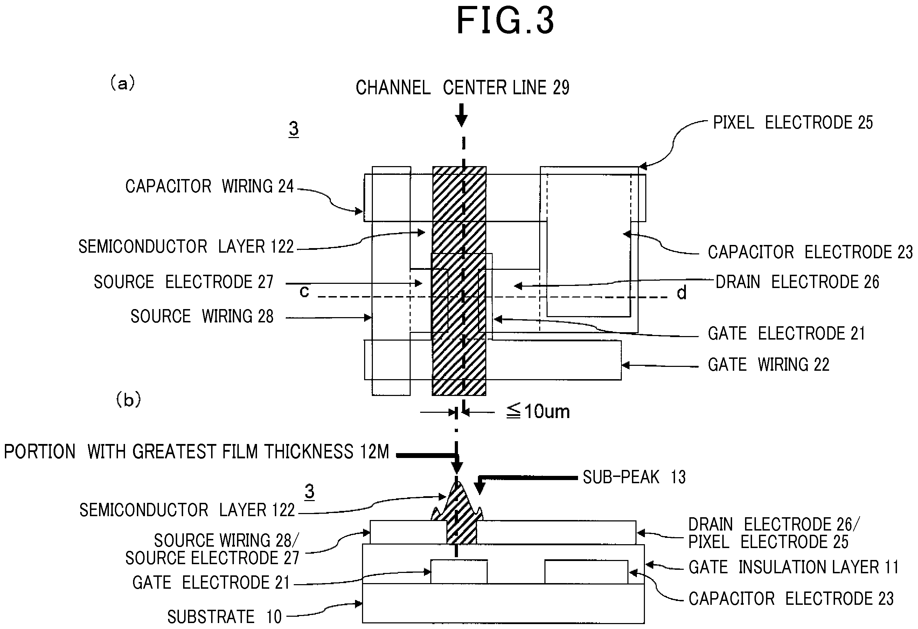

Fig. 3 is a set of diagrams including a schematic plan view and a schematic cross-sectional view taken along the line c-d of the plan view according to an example of the thin-film transistor configuring the thin-film transistor array 1. It should be noted that the components common with the thin-film transistor 2 are designated with the same reference signs to omit duplicate description.

As shown in Fig. 3 (b), a stripe shaped semiconductor layer 122 of the thin-film transistor 3 has a cross-sectional shape in the short axis direction in which the thickness gradually decreases towards lateral directions from the center of the semiconductor stripe area in the channel length direction. Furthermore, the cross-sectional shape has sub-peaks 13 on both ends of the semiconductor layer 122. The sub-peaks 13 each have a thickness smaller than the thickness 12M of the center portion.

The thin-film transistor 3 configured as described above can achieve high-performance transistor characteristics because the position of the thick portion of the semiconductor layer 122 falls within the channel region if the semiconductor layer 122 is displaced to an extent corresponding to approximately the channel length when forming the semiconductor layer 122.

Further, as shown in Fig. 3 (b), the sub-peaks 13 may overlap with the source electrode 27 and the drain electrode 26 in plan view.

The thin-film transistor 3 configured as described above can reduce the contact resistance between the semiconductor layer 122 and the source electrode 27 or the drain electrode 26, and thus high-performance transistor characteristics can be obtained. For example, satisfactory characteristics can be obtained if the contact length (length across which the semiconductor layer 122 contacts the surface of the source electrode 27 or the drain electrode 26) is designed to be about 5 µm.

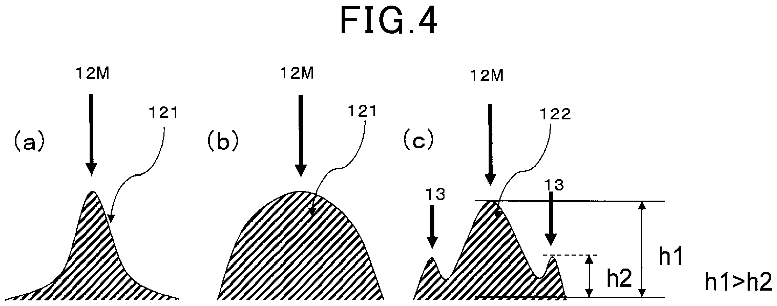

Fig. 4 shows a set of diagrams each showing a cross-sectional shape of the semiconductor layer 121 or 122. The diagrams (a) and (b) of Figs. 4 are examples of the semiconductor layer 121 of the thin-film transistor 2. In both diagrams, the film thickness gradually decreases in the width direction (right-and-left direction in Fig. 4) that is the short axis direction. Fig. 4 (c) is an example of the semiconductor layer 122 of the thin-film transistor 3. The semiconductor layer 122 has a thickness which gradually decreases in the width direction (right-and-left direction in Fig. 4) that is the short axis direction and increases on both ends, and forms the respective sub-peaks 13 (h2) each having a thickness smaller than a thickness (h1) of the center portion.

A flexible substrate is desirably used as the insulative substrate 10. Examples of generally used material include plastic materials, such as polyethylene terephthalate (PET), polyimide, polyethersulfone (PES), polyethylene naphthalate (PEN) and polycarbonate. A glass substrate such as quartz or a silicon wafer can be used as the insulating substrate 10, but a plastic substrate is preferably used in consideration of the reduction in thickness and weight and achievement of flexibility. Further, in consideration of the temperature used for the manufacturing processes, PEN or polyimide is desirably used as the substrate 10.

The materials used for the electrodes are not specifically limited, but the materials generally used for forming the thin films of the electrodes include metals and oxides, such as gold, platinum, nickel and indium tin oxide, solutions dispersed with a conductive polymer, such as poly (ethylenedioxythiophene)/polystyrene sulfonate (PEDOT/PSS) or polyaniline, or dispersed with metal colloidal particles such as of gold, silver or nickel, or thick film pastes using metal particles such as of silver, as a conductive material. Further, the method of forming the electrodes is not specifically limited, but a dry deposition method, such as vapor deposition or sputtering may be used. However, considering flexibility and cost reduction, a wet deposition method, such as screen printing, reverse offset printing, relief printing, or an inkjet method, is desirably used.

The materials used for the gate insulation layer 11 are not specifically limited, but generally used materials include polymer solutions such as of polyvinyl phenol, polymethylmethacrylate, polyimide, polyvinyl alcohol or an epoxy resin, or solutions dispersed with particles such as of alumina or silica gel. Further, a thin film made of PET, PEN or PES may be used as the gate insulation layer 11.

The materials used for the semiconductor layer 121 or 122 are not specifically limited, but generally used materials include high-molecular-weight organic semiconductor materials, such as polythiophene, polyallylamine, fluorene-bithiophene copolymer and derivatives thereof, and low-molecular-weight organic semiconductor materials, such as pentacene, tetracene, copper phthalocyanine, perylene and derivatives thereof. However, to achieve cost reduction, flexibility and area increase, it is desirable to use an organic semiconductor material to which a printing method can be applied. Further, carbon compounds, such as carbon nano-tubes or fullerene, or a semiconductor nano-particle dispersion may be used as a semiconductor material. Printing methods that can be used for forming the organic semiconductor layer include known methods, such as gravure printing, offset printing, screen printing and ink-jet methods. Generally, the semiconductor materials mentioned above have low solubility in a solvent, and thus it is desirable to use a method, such as relief printing, reverse offset printing or ink jet method, or a method using a dispenser, suitable for low viscosity solutions. Relief printing is particularly preferable since the short printing period can reduce the amount of ink used and thus reduce the cost incurred in printing by increasing the usage efficiency of the ink, in conjunction with reducing environmental load compared to photolithography. Also, relief printing is suitable for printing the stripe shaped semiconductor layer 121 or 122. Further, the semiconductor layer 121 or 122 formed into a stripe shape can contribute to averaging the distribution of thickness variation in a stripe shape area due to the unevenness of an anilox roll to thereby fix the thickness of the semiconductor layer 121 or 122 and make the TFT properties uniform. Further, the cross-sectional shape of the semiconductor layer 121 or 122 in terms of thickness can be easily achieved by using relief printing and optimizing the printing conditions.

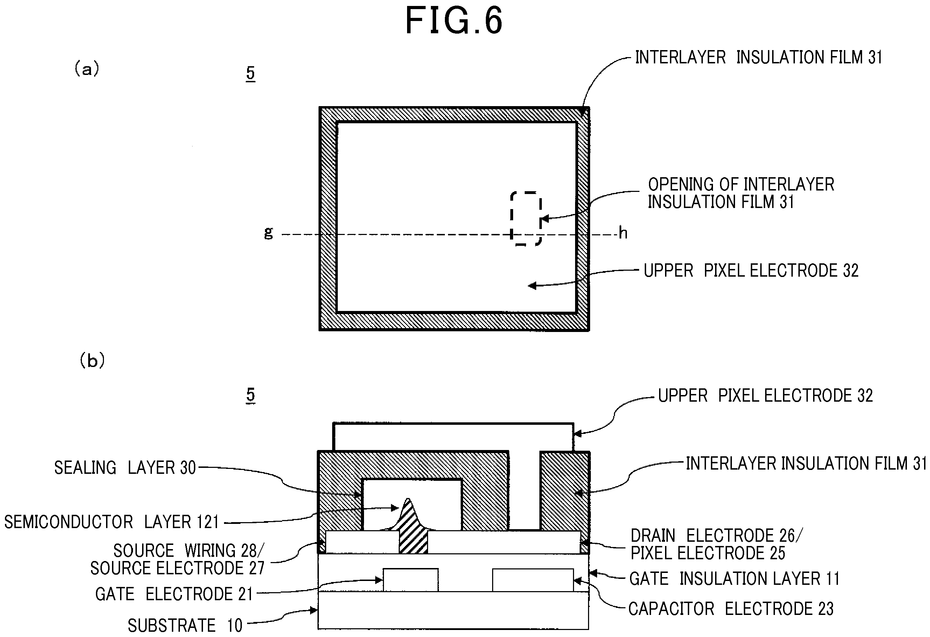

The thin-film transistor array 1 of the present invention may be provided with a sealing layer 30, a gas barrier layer (not shown), a planarizing film (not shown), an interlayer insulation film 31, an upper pixel electrode 32, and the like, as needed (Fig. 6). Fig. 6 shows a thin-film transistor 5 obtained by forming the sealing layer 30 covering the semiconductor layer 121, the interlayer insulation film 31 having an opening on the pixel electrode 25, and the upper pixel electrode 32 connected to the pixel electrode 25 via the opening, on the thin-film transistor 2 shown in Fig. 2. Fig. 6 is a set of diagrams including a schematic plan view and a schematic cross-sectional view taken along the line g-h of the plan view. Specifically, when an organic semiconductor material is used as the semiconductor layer 121 or 122, the semiconductor layer 121 or 122 may be damaged by the solvent or the like, depending on the material of the interlayer insulation film 31. Therefore, it is preferable to provide the sealing layer 30 between the semiconductor layer 121 or 122 and the interlayer insulation film 31 (insulating layer formed on the semiconductor layer 121 or 122, the source electrode 27, and the drain electrode 26).

Fig. 6 is an example in which the thin-film transistor 2 of Fig. 2 is provided thereon with the sealing layer 30, the interlayer insulation film 31, and the upper pixel electrode 32. Alternatively, the sealing layer 30, the interlayer insulation film 31, and the upper pixel electrode 32 may be provided on the thin-film transistor 3 of Fig. 3. Also, a display medium can be sandwiched between the thin-film transistor array shown in Fig. 2, 3 or 6 and a counter substrate having a counter electrode to thereby provide a display. In this case, in Fig. 2 or 3, the pixel electrode 25 applies a voltage to the display medium to contribute to displaying, and in Fig. 6, the upper pixel electrode 32 applies a voltage to the display medium to contribute to displaying. In this case, it is desirable that the thin-film transistor array of Fig. 2 or 3 further includes a sealing layer 30, with the sealing layer 30 covering not only the semiconductor layer 121, but also the source electrode 27 and the source wiring 28. Alternately, it is desirable that the thin-film transistor array of Fig. 2 or 3 further includes a sealing layer 30 and an interlayer insulation film 31, with the sealing layer 30 covering at least the semiconductor layer 121, and with the interlayer insulation film 31 covering the source electrode 27 and the source wiring 28.

In thin film transistor arrays, source and drain are named for the sake of convenience, and thus may be named conversely. In the present invention, the electrode connected to the source wiring is referred to as a source electrode, and the electrode connected to the pixel electrode is referred to as a drain electrode.

Hereinafter, examples will be described.

In the present invention, carrier mobility [cm²/Vs] which can be suitably applied to an electronic device of a display device, such as an electronic paper, is preferably 0.1 or more as a target value. Further, it is preferable that an on-current is 0.5 pA or more and an off-current is 0.5 pA or less.

### Example 1

Example 1 will be described. In the present example, a thin-film transistor array was fabricated using bottom-gate bottom-contact type thin-film transistors 2 as shown in Figs. 1 and 2 (enlarged view and cross-sectional view). A polyethylene naphthalate (PEN) film was used as the substrate 10. A gate electrode 21, a gate wiring 22, a capacitor electrode 23, and a capacitor wiring 24 were formed on the substrate 10 by use of an ink jet method and an ink having dispersed silver nanoparticles. Polyimide was applied as a gate insulation layer 11 by use of a die coater, followed by drying for 1 hour at 180°C, thereby forming the gate insulation layer 11. Then, a source electrode 27, a drain electrode 26, a source wiring 28 and a pixel electrode 25 were formed on the gate insulation layer 11 by use of an ink jet method and an ink having dispersed silver nanoparticles. Poly[2,5-bis(3-tetradecylthiophen-2-yl)thieno[3,2-b]thiophene] was used as the semiconductor material. As a preliminary experiment, a thin-film transistor was formed with inclusion of a semiconductor layer whose thickness had been changed using a spin-coating method, followed by measuring the drain current. The drain current increased with the increase of the thickness of the semiconductor layer, but the drain current was saturated at 50 nm or more. Then, dichlorobenzene having 0.5 wt% of the material dissolved therein was used as an ink. Further, a relief printing plate made of a photosensitive resin was used to print a stripe shaped semiconductor by relief printing, followed by drying for 60 minutes at 180°C, thereby forming a semiconductor layer 121. The stripe shaped semiconductor layer 121 had a cross-sectional shape in which the center portion was thick but gradually thinned towards both sides, and the thickness of the portion 12M with a maximum thickness was 70 nm. The distance d in plan view was 5 µm, the distance d being the length between the portion 12M of the stripe shaped semiconductor layer with the maximum thickness and the center 29 of the channel region. As a result, high-performance transistor characteristics were obtained, and uniformity of the transistor characteristics was high in the thin-film transistor array.

### Example 2

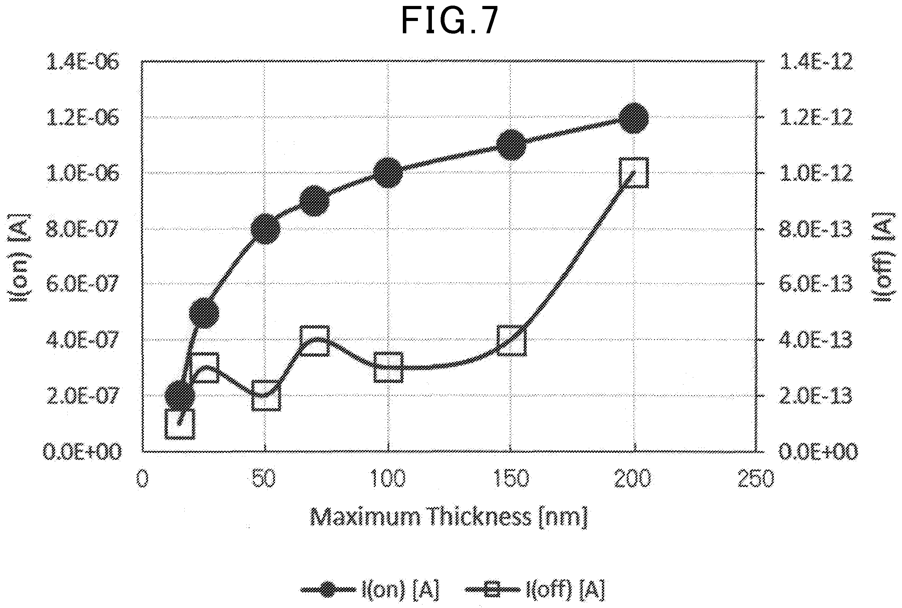

Elements of a striped semiconductor layer 121 (having a shape in which the center portion was thick but gradually thinned towards both sides) were fabricated by the same method as in Example 1. The semiconductor layer 121 had a channel length of 10 µm, a width of 100 µm, a maximum thickness of 15 nm, 25 nm, 50 nm, 70 nm, 100 nm, 150 nm or 200 nm, and had a distance d=0 µm between the maximum thickness portion and the center of the channel. In this case, an Id at Vd=-15V and Vg=-20V was taken to be an on-current, and an Id at Vd=-15V and Vg=+20V was taken to be an off-current, and the values were plotted as shown in Fig. 7. The on-current was 0.5 pA or more when the maximum thickness was 25 nm or more, and the off-current was 0.5 pA or less when the maximum thickness was 150 nm or less. In all cases, uniformity of the transistor characteristics was high.

### Example 3

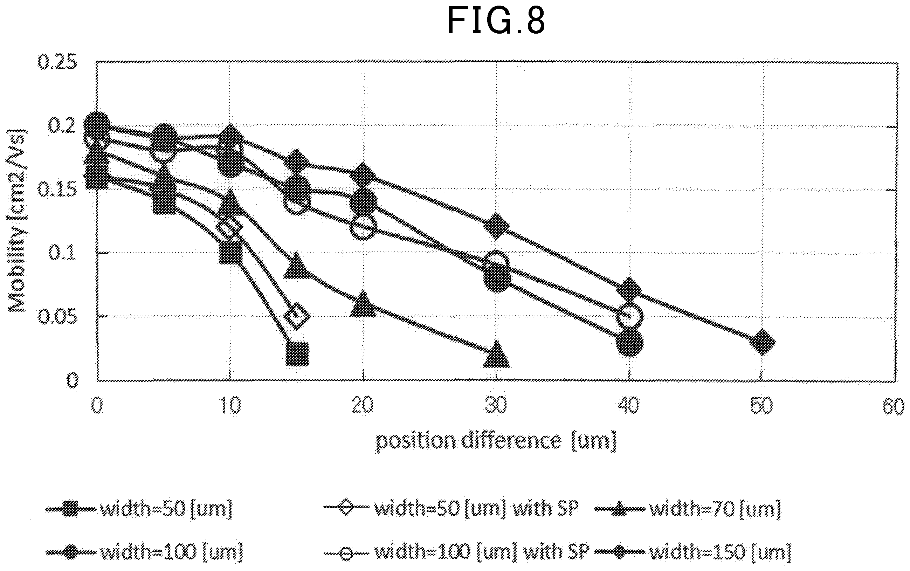

Elements of a striped semiconductor layer 121 (having a shape in which the center portion is thick but gradually thinned towards both sides) were fabricated by the same method as in Example 1. The semiconductor layer 121 had a channel length of 10 µm, a maximum thickness of 70 nm, a width of 50 µm, 70 µm, 100 µm or 150 µm, and had the distance d=0 µm, 5 µm, 10 µm, 15 µm, 20 µm, 30 µm, 40 µm or 50 µm between the maximum thickness portion and center of the channel, and mobility in this case was plotted as shown in Fig. 8. A mobility of 0.1 cm²/Vs or more was obtained when the distance d was 10 µm or less between the maximum thickness portion and the channel center. In all cases, uniformity of the transistor characteristics was high.

### Example 4

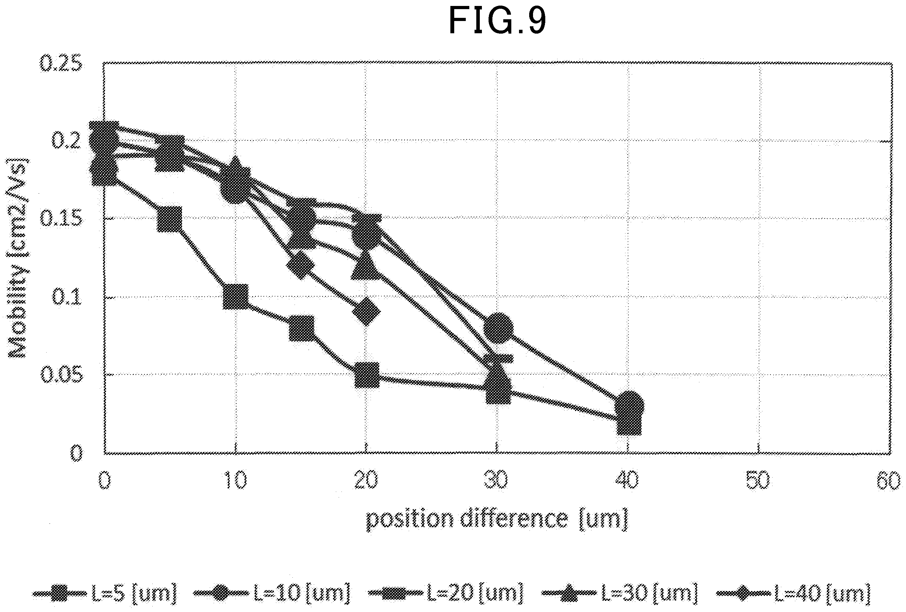

Elements of a striped semiconductor layer 121 (having a shape in which the center portion is thick but gradually thinned towards both sides) were fabricated by the same method as in Example 1. The semiconductor layer 121 had a maximum thickness of 70 nm, a width of 100 µm, a channel length of 5 µm, 10 µm, 20 µm, 30 µm or 40 µm, and had the distance d=0 µm, 5 µm, 10 µm, 15 µm, 20 µm, 30 µm, 40 µm, or 50 µm between the maximum thickness portion and the center of the channel, and mobility in this case was plotted as shown in Fig. 9. A mobility of 0.1 cm²/Vs or more was obtained when the distance d was 10 µm or less between the maximum thickness portion and the channel center. In all cases, uniformity of the transistor characteristics was high.

### Example 5

Example 5 will be described. In the present example, a thin-film transistor array was fabricated using the bottom-gate bottom-contact type thin-film transistors 3 shown in Figs. 1 and 3 (enlarged view and cross-sectional view). Example 5 was similar to Example 1, except that the pressing amount when the ink was transferred to the substrate 10 in forming the semiconductor layer 122 was increased by 20 µm compared to in Example 1. In this case, the semiconductor layer 122 had a cross-sectional shape in terms of thickness in which the center portion was thick but gradually thinned towards both sides, with the sub-peaks 13 being further provided. The portion 12M with a maximum thickness had a thickness of 70 nm, while the sub-peaks each had a thickness of 40 nm in both ends of the cross section of the semiconductor layer in the channel length direction. Further, the distance d in plan view was 5 µm between the portion 12M having the maximum thickness and the center 29 of the channel region. Thus, high-performance transistor characteristics were obtained and high uniformity was achieved in the transistor characteristics of the thin-film transistor array.

### Example 6

The elements of the striped semiconductor layer 122 (having a shape in which the center portion was thick but gradually thinned towards both sides, with sub-peaks being further provided) were fabricated by the same method as in Example 5. The semiconductor layer 122 had a channel length of 10 µm, a maximum thickness of 70 nm, a sub-peak thickness of 40 nm, a width of 50 µm or 100 µm, and had the distance d=0 µm, 5 µm, 10 µm, 15 µm, 20 µm, 30 µm or 40 µm between the maximum thickness portion and the center of the channel, and mobility was plotted as shown in Fig. 8 by hollow marks. A higher mobility than in Example 3 was obtained when an overlap of the source and drain electrodes with the semiconductor layer in width direction was 5 µm to 15 µm. In all cases, uniformity of the transistor characteristics was high.

### (Comparative Example)

A Comparative Example will be described. The Comparative Example was similar to Example 1, except that the printing conditions in Example 1 were changed such that the semiconductor layer had a cross-sectional shape in terms of thickness in which the center portion was not thinned towards both sides, with no provision of sub-peaks. Under such printing conditions, the thickness of the semiconductor layer was uneven, and the current characteristics of the channel portion varied. Thus, in the Comparative Example, uniformity of the transistor characteristics was low.

Consequently, the thin-film transistor arrays of the Examples were confirmed to have uniformity in the transistor characteristics. Further, it was also confirmed that higher transistor characteristics were achieved if a 10 µm or less distance was ensured between the portion of the semiconductor layer with the maximum thickness and the center of the channel region in the channel length direction.

### [Industrial Applicability]

The technique of the present invention is useful for thin-film transistor arrays, and thus is useful for electrophoretic displays, liquid crystal displays, and the like which use the thin-film transistor arrays based on the technique of the present invention.

### [Reference Signs List]

- 1: Thin-film transistor array
- 2,3,4: Thin-film transistor
- 10: Substrate
- 11: Gate insulation layer
- 121,122,123: Semiconductor layer
- 12M: Portion of semiconductor layer with maximum thickness
- 13: Sub-peak
- 21: Gate electrode
- 22: Gate wiring
- 23: Capacitor electrode
- 24: Capacitor wiring
- 25: Pixel electrode
- 26: Drain electrode
- 27: Source electrode
- 28: Source wiring
- 29: Channel center line
- 30: Sealing layer
- 31: Interlayer insulation film
- 32: Upper pixel electrode

## Claims

1. A thin-film transistor array in which a plurality of thin-film transistors are arranged in a matrix on a substrate, the thin-film transistors each including a source electrode and a drain electrode formed on a gate insulation layer, and a semiconductor layer formed on the gate insulation layer so as to be located between the source electrode and the drain electrode, wherein:
the semiconductor layer is formed into a stripe shape across the plurality of thin-film transistors, with a long axis direction of the stripe coinciding with a channel width direction of a transistor, the semiconductor layer having a cross section in the short axis direction of the stripe such that the semiconductor layer has a thickness gradually decreasing outwardly from a center of the semiconductor.

2. The thin-film transistor array according to claim 1, wherein a 10 µm or less distance is ensured between a portion of the semiconductor layer with a maximum thickness and the center of the channel region relative to a channel length direction.

3. The thin-film transistor array according to claim 1 or 2, **characterized in that** the portion of the semiconductor layer with a maximum thickness has a thickness in a range of 25 nm or more to 150 nm or less.

4. The thin-film transistor array according to any one of claims 1 to 3, wherein the stripe of the semiconductor layer has a cross-sectional shape in a short axis direction such that the semiconductor layer has a thickness gradually decreasing outwardly from a center, with sub-peaks being provided on both ends of the semiconductor layer, the sub-peaks each having a thickness smaller than the thickness of the center portion.

5. The thin-film transistor array according to claim 4, wherein the sub-peaks on both ends of the semiconductor layer respectively overlap, in plan view, with the source electrode and the drain electrode.

6. A method of manufacturing the thin-film transistor array according to any one of claims 1 to 5 comprising a step of forming the semiconductor layer using a relief printing method.
